# EUROPEAN PATENT APPLICATION

(11) **EP 4 389 929 A1**
(43) Date of publication of application: **26.06.2024**
(21) Application number: 22216121.8
(22) Date of filing: 22.12.2022
(51) Int. Cl.: C23C 14/56, C23C 16/54

(54) **APPARATUS FOR DEPOSITING MATERIAL LAYERS ON A SUBSTRATE**

(71) Applicant: Swiss Cluster AG, 3602 Thun (CH); Eidgenössische Materialprüfungs- und Forschungsanstalt, 8600 Dübendorf (CH)
(72) Inventor: GUERRA, Carlos, 3018 Bern (CH); PETHO, Laszlo, 3012 Bern (CH); MICHLER, Johann, 3653 Oberhofen (CH)
(74) Representative: Keller Schneider Patent- und Markenanwälte AG

(57) **Abstract**

The invention relates to an apparatus (1) for depositing material layers on a substrate (100) with chemical vapour deposition, in particular atomic layer deposition, and physical vapour deposition. The apparatus (1) includes a substrate holder (2) for holding the substrate (100) during deposition of the material layers, a chemical vapour deposition chamber (3), in particular an atomic layer deposition chamber, and a physical vapour deposition chamber (4), wherein the physical vapour deposition chamber (4) and the chemical vapour deposition chamber (3) are interconnected via an opening (5) having a minimal opening diameter. The apparatus (1) further includes a sealing device (6) for isolating the chemical vapour deposition chamber (3) from the physical vapour deposition chamber (4) by sealing said opening (5), the sealing device (6) being switchable between a sealing state in which sealing state the chemical vapour deposition chamber (3) is isolated from the physical vapour deposition chamber (4) in that the opening (5) is sealed by the sealing device (6), and an unsealing state in which unsealing state the isolation of the chemical vapour deposition chamber (3) from the physical vapour deposition chamber (4) by the sealing device (6) is revoked. Furthermore, the apparatus (1) includes means (8) for depositing at least one PVD layer by physical vapour deposition on the substrate (100), each one of the at least one PVD layer being one of the material layers. Thereby the apparatus (1) is switchable to a physical vapour deposition configuration for depositing the at least one PVD layer with the means (8) for depositing the at least one PVD layer by physical vapour deposition on the substrate (100). Additionally, the apparatus (1) includes means (7) for depositing at least one CVD layer by chemical vapour deposition, in particular by atomic layer deposition, on the substrate (100), each one of the at least one CVD layer being one of the material layers. Thereby, the apparatus (1) is switchable to a chemical vapour deposition configuration for depositing the at least one CVD layer with the means (7) for depositing the at least one CVD layer by chemical vapour deposition on the substrate (100). In said physical vapour deposition configuration, a distance between the substrate holder (2) and the means (8) for depositing the at least one PVD layer by physical vapour deposition is smaller than the minimal opening diameter.

## Description

### Technical Field

The invention relates to an apparatus for depositing material layers on a substrate with chemical vapour deposition, in particular atomic layer deposition, and physical vapour deposition. This apparatus includes a substrate holder for holding the substrate during deposition of said material layers, a chemical vapour deposition chamber, in particular an atomic layer deposition chamber, and a physical vapour deposition chamber. Thereby, the physical vapour deposition chamber and the chemical vapour deposition chamber are interconnected via an opening having a minimal opening diameter. The apparatus further includes a sealing device for isolating the chemical vapour deposition chamber from the physical vapour deposition chamber by sealing the opening, the sealing device being switchable between a sealing state in which sealing state the chemical vapour deposition chamber is isolated from the physical vapour deposition chamber in that the opening is sealed by the sealing device, and an unsealing state in which unsealing state the isolation of the chemical vapour deposition chamber from the physical vapour deposition chamber by the sealing device is revoked. Furthermore, the apparatus includes means for depositing at least one PVD layer by physical vapour deposition on the substrate, each one of the at least one PVD layer being one of the material layers, wherein the apparatus is switchable to a physical vapour deposition configuration for depositing the at least one PVD layer with the means for depositing the at least one PVD layer by physical vapour deposition on the substrate. Furthermore, the apparatus includes means for depositing at least one CVD layer by chemical vapour deposition, in particular by atomic layer deposition, on the substrate, each one of the at least one CVD layer being one of the material layers, wherein the apparatus is switchable to a chemical vapour deposition configuration for depositing the at least one CVD layer with the means for depositing the at least one CVD layer by chemical vapour deposition on the substrate.

### Background Art

In the present text, the abbreviation PVD refers to physical vapour deposition. Physical vapour deposition processes are widely known. The most common ones are evaporation and sputtering. In evaporation, a target is heated up such that hot target material evaporates. This evaporated target material then condenses on the substrate and forms a layer of the target material on the substrate. Thereby, the material may react with a further reactive gas present in the PVD chamber during condensation or before condensation. In sputtering, on the other hand, the material from the target is ejected onto a substrate in order to deposit a layer of the material on the substrate. For this reason, in sputtering, often a sputtering gas is employed which is usually an inert gas like argon. This sputtering gas is ionised to charged plasma particles which are directed onto the target in order to eject material from the target. Thereby, if desired, a reactive gas can be used as sputtering gas or a reactive gas can be added to the sputtering gas such that the target material reacts with the reactive gas before or after deposition on the substrate. In sputtering processes where a sputtering gas is employed, the sputter source often employs a magnetron that utilises strong electric and magnetic fields to confine the charged plasma particles close to the surface of the sputter target. The area containing an increased concentration of these charged plasma particles is referred to as the plasma sheath. Such sputter sources which employ a magnetron are referred to as magnetron sputter sources, while the corresponding process is referred to as magnetron sputtering.

In the present text, the abbreviation CVD refers to chemical vapour deposition. In typical chemical vapour deposition, the substrate is exposed to one or more volatile precursors, which react and/or decompose on the surface of the substrate to produce the desired deposit and thus deposit the desired CVD layer on the substrate. Sometimes, volatile by-products are also produced. Such by-products can be removed by a gas flow through the reaction chamber. Chemical vapour deposition processes are widely known. They are sometimes classified in classification systems like atmospheric pressure CVD and low pressure CVD. Sometimes, they are classified by the physical characteristics of the vapour like aerosol assisted CVD and direct liquid injection CVD. Sometimes they are classified by the type of how the substrate is heated. Overall, as a non-exhaustive list, there are chemical vapour deposition processes known like atomic layer deposition, combustion chemical vapour deposition, hot filament vapour deposition, metalorganic chemical vapour deposition, vapour-phase epitaxy, photo-initiated chemical vapour deposition, rapid thermal chemical vapour deposition and laser chemical vapour deposition.

Atomic layer deposition, which is a type of chemical vapour deposition, is abbreviated in the present text as ALD. Atomic layer deposition is based on the sequential use of a gas-phase chemical process. Thereby, one or more precursors, most often however two precursors, react with the surface of a substrate on which an ALD layer is to be deposited. Thereby, the precursors react sequentially, one at the time, with the surface. Thus, the precursors react in a self-limiting manner. Thereby, in case of more than one precursor, an ALD layer is slowly deposited through repeated exposure to the separate precursors, while in case of one precursor, the ALD layer is slowly deposited through exposure to the one precursor.

In general, PVD processes for deposition of material layers are much faster than CVD processes for deposition of layers.

Apparatuses for depositing material layers on a substrate with chemical vapour deposition and physical vapour deposition pertaining to the technical field initially mentioned are known. One example of such an apparatus is described in US 2002/0096114 A1 of Applied Materials, Inc. This apparatus comprises a body having a front end portion defining a first processing region and a back end portion defining a second processing region. The first processing region is adapted for chemical vapour deposition (CVD). The second processing region is adapted for physical vapour deposition (PVD). Between the two processing regions, there is a transfer passageway for transferring the substrate from the first processing region to the second processing region and back. This transfer passage way can be sealed by a sealing device. The apparatus further comprises a substrate handler disposed on the body and comprising a substrate support arm positionable alternatively in the first processing region and the second processing region. This substrate handler enables the transfer of the substrate from the first processing region to the second processing region and bacl<. However, due to the movement of the substrate from the first processing region to the second processing region and back required for depositing material layers on the substrate with chemical vapour deposition and physical vapour deposition, this apparatus does not enable a fast and efficient deposition of different material layers with chemical vapour deposition and physical vapour deposition on the substrate.

Another example of an apparatus for depositing material layers on a substrate with chemical vapour deposition, in particular atomic layer deposition, and physical vapour deposition pertaining to the technical field is described in EP 3 957 767 A1 of EMPA Eidgenössische Materialprüfungs- und Forschungsanstalt. This apparatus enables a fast and efficient deposition of different material layers with chemical vapour deposition and physical vapour deposition on the substrate because the substrate held in the substrate holder can be kept in the chemical vapour deposition chamber while depositing at least one PVD layer by physical vapour deposition on the substrate. However, this apparatus described in EP 3 957 767 A1 has the disadvantage that it does not enable a reliable deposition of very homogeneous material layers having a uniform thickness.

In the present text, the formulation "and/or" is occasionally used for linking two features. This formulation is to be understood as either one of the two features or both of the features. Thus, "A and/or B" is to be understood as three equivalent options, wherein one option is A, another option is B and yet another option is both A and B.

### Summary of the invention

It is the object of the invention to create an apparatus for depositing material layers on a substrate with chemical vapour deposition, in particular atomic layer deposition, and physical vapour deposition, pertaining to the technical field initially mentioned, that enables a reliable, fast and efficient deposition of different material layers with chemical vapour deposition and physical vapour deposition on the substrate, the material layers being very homogeneous and having a uniform thickness.

The solution of the invention is specified by the features of claim 1. According to the invention, in the physical vapour deposition configuration, a distance between the substrate holder and the means for depositing the at least one PVD layer by physical vapour deposition is smaller than the minimal opening diameter.

According to the invention, the apparatus is for depositing material layers on a substrate with chemical vapour deposition, in particular atomic layer deposition, and physical vapour deposition. Thereby, the apparatus is advantageously for depositing at least two material layers on the substrate with chemical vapour deposition, in particular atomic layer deposition, and physical vapour deposition. In particular, the apparatus is advantageously for depositing at least one CVD layer, in particular at least one ALD layer, and at least one PVD layer on the substrate. Thereby, the at least one CVD layer, which may be at least one ALD layer, and the at least one PVD layer are material layers. In this case, the at least two material layers advantageously include at least one CVD layer, in particular at least one ALD layer, and at least one PVD layer. Nonetheless, the apparatus can also be employed for depositing only one or more CVD layers or ALD layers, respectively. Similarly, the apparatus can also be employed for depositing only one or more PVD layers.

According to the invention, the apparatus includes a substrate holder for holding the substrate during deposition of the material layers. Furthermore, according to the invention, the apparatus includes a physical vapour deposition chamber and a chemical vapour deposition chamber. Thereby, in case an atomic layer deposition process is used as the chemical vapour deposition process for depositing those material layers which are CVD layers, the chemical vapour deposition chamber can also be referred to as atomic vapour deposition chamber, while the CVD layers can also be referred to as ALD layers.

According to the invention, the physical vapour deposition chamber and the chemical vapour deposition chamber or atomic vapour deposition chamber, respectively, are interconnected via an opening having a minimal opening diameter. Thereby, the opening advantageously provides an aperture defining an aperture plane. Thus, the opening advantageously lies in the aperture plane. Consequently, a gas molecule moving within the aperture from one side of the aperture plane to the other side of the aperture moves through the opening from the physical vapour deposition chamber to the chemical vapour deposition chamber or from the chemical vapour deposition chamber to the physical vapour deposition chamber. The minimal opening diameter is advantageously measured within the aperture plane. Advantageously, the minimal opening diameter is the smallest diameter of the opening measured through the geometric centre of the opening. Thus, for example, in case the opening has a circular shape, the minimal opening diameter is the diameter of the circle of the circular shape of the opening. For example, in case the opening has a square shape, the minimal opening diameter is the length of a side of the square of the square shape of the opening. For example, in case the opining has a rectangular shape, the minimal opening diameter is the length of a shorter side of the rectangle of the rectangular shape of the opening.

Advantageously, the physical vapour deposition chamber is arranged adjacent to the chemical vapour deposition chamber. Thus, a distance from the physical vapour deposition chamber to the chemical vapour deposition chamber is advantageously smaller than the minimal opening diameter of the opening interconnecting the physical vapour deposition chamber and the chemical vapour deposition chamber. Alternatively, however, the physical vapour deposition chamber is arranged further away from the chemical vapour deposition chamber.

According to the invention, the apparatus includes a sealing device for isolating the chemical vapour deposition chamber from the physical vapour deposition chamber by sealing the opening, the sealing device being switchable between a sealing state in which sealing state the chemical vapour deposition chamber is isolated from the physical vapour deposition chamber in that the opening is sealed by the sealing device, and an unsealing state in which unsealing state the isolation of the chemical vapour deposition chamber from the physical vapour deposition chamber by the sealing device is revoked.

According to the invention, the apparatus includes means for depositing at least one PVD layer by physical vapour deposition on the substrate, each one of the at least one PVD layer being one of the material layers, wherein the apparatus is switchable to a physical vapour deposition configuration for depositing the at least one PVD layer with the means for depositing the at least one PVD layer by physical vapour deposition on the substrate. In one example, the means for depositing the at least one PVD layer is or includes a sputter source like a magnetron sputter source. In another example, the means for depositing the at least one PVD layer is or includes a heating source for evaporating a target material to be deposited in a PVD layer on the substrate. In another example, the means for depositing the at least one PVD layer is or includes an electron beam source for generating and directing an electron beam on a target to vaporise the target material to be deposited in a PVD layer on the substrate. In yet another example, the means for depositing the at least one PVD layer is or includes a laser for generating and directing a laser beam on a target to vaporise the target material to be deposited in a PVD layer on the substrate.

According to the invention, the apparatus includes means for depositing at least one CVD layer by chemical vapour deposition, in particular by atomic layer deposition, on the substrate, each one of the at least one CVD layer being one of the material layers, wherein the apparatus is switchable to a chemical vapour deposition configuration for depositing the at least one CVD layer with the means for depositing the at least one CVD layer by chemical vapour deposition on the substrate. In one example, the means for depositing the at least one CVD layer by atomic layer deposition and thus by chemical vapour deposition is or includes at least one precursor inlet for introducing gas precursors into the atomic layer deposition chamber and thus into the chemical vapour deposition chamber in order to lead to a deposition of the at least one ALD layer being the at least one CVD layer by chemical reactions of the gas precursors. In another example, the means for depositing the at least one CVD layer is or includes a gas inlet for inserting a gas into the chemical vapour deposition chamber and an energy source like a hot filament, a microwave source or an arc discharge source for generating a plasma in the chemical vapour deposition chamber in which the gas inserted through the gas inlet into the chemical vapour deposition chamber is broken down, enabling the chemical reactions required for the deposition of the at least one CVD layer. In yet another example, the means for depositing the at least one CVD layer includes or is a gas inlet for inserting a gas into the chemical vapour deposition chamber and a substrate heating element for heating the substrate held in the substrate holder for enabling the chemical reactions of the gas inserted through the gas inlet into the chemical vapour deposition chamber for enabling the deposition of the at least one CVD layer.

According to the invention, in the physical vapour deposition configuration, the distance between the substrate holder and the means for depositing the at least one PVD layer by physical vapour deposition is smaller than the minimal opening diameter. This has the advantage that in the physical vapour deposition configuration, during deposition of the at least one PVD layer, the substrate can be held by the substrate holder at a deposition distance from the means for depositing the at least one PVD layer by physical vapour deposition being small as compared to the minimal opening diameter. This enables the deposition of very homogeneous PVD layers having a uniform thickness in the physical vapour deposition configuration. The reason is that in case in the physical vapour deposition configuration, the substrate holder with the substrate is kept in the chemical vapour deposition chamber while the means for depositing the at least one PVD layer by physical vapour deposition on the substrate and the target from which material is evaporated for depositing the at least one PVD layer on the substrate are kept in the physical vapour deposition chamber, the evaporated material for depositing the at least one PVD layer on the substrate can pass from the target to the substrate via the opening. Thereby, the opening provides an aperture which is large as compared to the distance between the substrate holder and the means for depositing the at least one PVD layer on the substrate such that the opening does not form any sort of diaphragm altering the shape of the cloud of material passing from the means for depositing the at least one PVD layer to the substrate. Thus, the evaporated material for depositing the at least one PVD layer on the substrate can pass unhindered from the target to the substrate via the opening. Consequently, the deposition on the substrate of very homogeneous PVD layers having a uniform thickness is enabled. Similarly, in case in the physical vapour deposition configuration, the substrate holder with the substrate is kept in the chemical vapour deposition chamber while the means for depositing the at least one PVD layer by physical vapour deposition on the substrate is moved from the physical vapour deposition chamber into the chemical vapour deposition chamber, the deposition of a very homogeneous PVD layers having a uniform thickness is enabled because the means for depositing the at least one PVD layer to the substrate can be constructed comparably large and can still be moved through the opening from the physical vapour deposition chamber to the chemical vapour deposition chamber for depositing the at least one PVD layer on the substrate. Thus, by the comparably large means for depositing the at least one PVD layer to the substrate, a cloud of material passing from the means for depositing the at least one PVD layer to the substrate can be generated for depositing the at least one PVD layer on the substrate, the cloud being particularly homogeneous along the entire surface of the substrate on which the at least one PVD layer is to be deposited. Consequently, the deposition of a very homogeneous PVD layers having a uniform thickness is enabled. Similarly, in case in the physical vapour deposition configuration, the substrate holder with the substrate is moved from the chemical vapour deposition chamber via the opening to the physical vapour deposition chamber while the means for depositing the at least one PVD layer by physical vapour deposition on the substrate is kept in the physical vapour deposition chamber, the deposition of a very homogeneous PVD layers having a uniform thickness is enabled because the means for depositing the at least one PVD layer to the substrate can be constructed comparably large in order to generate a cloud of material passing from the means for depositing the at least one PVD layer to the substrate for depositing the at least one PVD layer on the substrate, the cloud being particularly homogeneous at a position along the surface of the substrate on which the at least one PVD layer is to be deposited. Consequently, the deposition of a very homogeneous PVD layers having a uniform thickness is enabled. These advantages are particularly pronounced in case the apparatus is adapted such that in the physical vapour deposition configuration, the deposition distance between the substrate held by the substrate holder and the means for depositing the at least one PCV layer by physical vapour deposition is smaller than the minimal opening diameter.

Advantageously, in the physical vapour deposition configuration, the distance between the substrate holder and the means for depositing the at least one PVD layer by physical vapour deposition, in particular the distance between the substrate held in the substrate holder and the means for depositing the at least one PVD layer by physical vapour deposition, is smaller than 30 cm, particular advantageously smaller than 20 cm, more advantageously less than 10 cm. Thereby, the smaller the distance between the substrate holder and the means for depositing the at least one PVD layer by physical vapour deposition or the distance between the substrate held in the substrate holder and the means for depositing the at least one PVD layer by physical vapour deposition, respectively, is, the easier it becomes to generate a cloud of material for depositing the at least one PVD layer by physical vapour deposition, the cloud being homogeneous along the surface of the substrate on which surface the at least one PVD layer is to be deposited.

Preferably, in the physical vapour deposition configuration, the distance between the substrate holder and the means for depositing the at least one PVD layer by physical vapour deposition, in particular the distance between the substrate held in the substrate holder and the means for depositing the at least one PVD layer by physical vapour deposition, is larger than 2 cm, particular preferably larger than 3 cm, more preferably larger than 4 cm, most preferably larger than 5 cm. Thereby, the larger the distance between the substrate holder and the means for depositing the at least one PVD layer by physical vapour deposition or the distance between the substrate held in the substrate holder and the means for depositing the at least one PVD layer by physical vapour deposition, respectively, is, the freer the deposition conditions for depositing the at least one PVD layer by physical vapour deposition can be chosen without compromising the quality of the at least one PVD layer being deposited on the substrate. In case an arc-discharge deposition method is employed for depositing the at least one PVD layer, this minimal distance minimises the risk for droplet formation on the substrate, thus enabling a freer choice of the setting of the parameters during deposition without compromising the quality of the at least one PVD layer being deposited on the substrate. In case sputtering deposition, in particular magnetron sputtering deposition, is employed for depositing the at least one PVD layer, the minimal distance enables a larger height of the plasma sheath above the sputter target without the plasma sheath touching the substrate. Thus, the plasma conditions can be chose more freely without compromising the quality of the at least one PVD layer being deposited on the substrate.

As an alternative to these variants, however, in the physical vapour deposition configuration, the distance between the substrate holder and the means for depositing the at least one PVD layer by physical vapour deposition, in particular the distance between the substrate held in the substrate holder and the means for depositing the at least one PVD layer by physical vapour deposition, is at least 30 cm or maximally 2 cm.

Preferably, the chemical vapour deposition chamber and the physical vapour deposition chamber are arranged on opposite sides of the sealing device. This has the advantage that the apparatus can be constructed very compactly while the opening can be sealed efficiently with the sealing device by switching the sealing device to the sealing state in order to isolate the chemical vapour deposition chamber from the physical vapour deposition chamber.

Alternatively, however, the chemical vapour deposition chamber and the physical vapour deposition chamber can be arranged on different sides of the sealing device than on opposite sides of the sealing device.

Advantageously, the apparatus includes a control unit for controlling the apparatus for depositing the material layers on the substrate with chemical vapour deposition, in particular atomic layer deposition, and physical vapour deposition. Thus, advantageously, the control unit is adapted for controlling the means for depositing the at least one CVD layer by chemical vapour deposition, in particular by atomic layer deposition, on the substrate. Furthermore, the control unit is advantageously adapted for controlling the means for depositing the at least one PVD layer by physical vapour deposition on the substrate.

In a first preferred variant, the control unit is further adapted to switch the apparatus to the chemical vapour deposition configuration for depositing the at least one CVD layer by chemical vapour deposition, in particular by atomic vapour deposition. In a second preferred variant, the control unit is further adapted to switch the apparatus to the physical vapour deposition configuration for depositing the at least one PVD layer by physical vapour deposition. In a third preferred variant, control unit is adapted to switch the apparatus to the chemical vapour deposition configuration for depositing the at least one CVD layer by chemical vapour deposition, in particular by atomic vapour deposition, and to switch the apparatus to the physical vapour deposition configuration for depositing the at least one PVD layer by physical vapour deposition.

In yet another variant, the control unit is neither adapted to switch the apparatus to the chemical vapour deposition configuration for depositing the at least one CVD layer by chemical vapour deposition, in particular by atomic vapour deposition, nor adapted to switch the apparatus to the physical vapour deposition configuration for depositing the at least one PVD layer by physical vapour deposition. In this case, the apparatus may include a configuration switching unit for switching the apparatus to the chemical vapour deposition configuration for depositing the at least one CVD layer by chemical vapour deposition, in particular by atomic vapour deposition, and for switching the apparatus to the physical vapour deposition configuration for depositing the at least one PVD layer by physical vapour deposition. This configuration switching unit may be a unit separate from the control unit. In yet another variant, the apparatus may be manually switchable to the chemical vapour deposition configuration for depositing the at least one CVD layer by chemical vapour deposition, in particular by atomic vapour deposition, and to the physical vapour deposition configuration for depositing the at least one PVD layer by physical vapour deposition.

As an alternative to these variants, the apparatus goes without a control unit.

Preferably, the means for depositing the at least one PVD layer by physical vapour deposition on the substrate includes a sputter source for sputter depositing the at least one PVD layer by sputtering sputter target material from a sputter target, wherein the distance between the substrate holder and the means for depositing the at least one PVD layer by physical vapour deposition is the distance between the substrate holder and the sputter source. Thus, advantageously, sputter deposition is used as physical vapour deposition for depositing the at least one PVD layer.

The means for depositing the at least one PVD layer by physical vapour deposition on the substrate including a sputter source for sputter depositing the at least one PVD layer by sputtering sputter target material from a sputter target has the advantage that a comparably cheap, fast and efficient way for depositing the at least one PVD layer is provided.

Advantageously, the sputter source includes the sputter target. In this case, the means for depositing the at least one PVD layer advantageously is the sputter source including the sputter target. In this case, advantageously, the distance between the substrate holder and the means for depositing the at least one PVD layer by physical vapour deposition is advantageously the distance between the substrate holder and the sputter target.

Alternatively, however, the sputter source may go without sputter target. Nonetheless, the sputter source advantageously includes a sputter target holder for holding the sputter target. Thereby, the sputter target is advantageously exchangeably mountable on the sputter target holder. Thus, a new sputter target can advantageously mounted on the sputter target holder once the previous sputter target has been consumed.

Advantageously, the sputter source includes a magnetron. In this case, the sputter deposition is advantageously magnetron sputter deposition. Thereby, the sputter target from which sputter target material is sputtered to be deposited for depositing the at least one PVD layer is advantageously mounted directly or indirectly on the magnetron. Thus, the sputter target holder is advantageously arranged on the magnetron or part of the magnetron. Alternatively, however, the sputter source does not include a magnetron. For example, the sputter source may include an ion beam source, wherein an ion beam from the ion beam source is directed onto the sputter target for sputtering sputter target material from the sputter target to be deposited for depositing the at least one PVD layer.

Advantageously, the minimal opening diameter is larger than a minimal sputter target diameter of the sputter target. Thereby, the minimal sputter target diameter is advantageously the smallest diameter of a cross section of the sputter target, this smallest diameter being measured through the geometric centre of the cross section of the sputter target, wherein the cross section of the sputter target is taken in a plane parallel to the aperture plane at a position perpendicular to the aperture plane where the cross section of the sputter target provides the largest area. This means that at all other positions perpendicular to the aperture plane, the sputter target provides a cross section having a smaller area.

When taking the cross section of the sputter target in the plane parallel to the aperture plane at the position perpendicular to the aperture plane where the cross section of the sputter target provides the largest area and projecting this cross section of the sputter target onto the aperture plane, the projection of the cross section of the sputter target is advantageously located within the aperture of the opening. Most advantageously, the projection of the cross section of the sputter target onto the aperture plane including a circumferential minimal border around the projection, the circumferential minimal border around the projection having a width of at least 1.5 cm, particular advantageously of at least 2 cm, is located within the aperture of the opening. This has the advantage that during operation of the sputter source, a border of the opening is distanced enough from the plasma sheath to prevent any damaging to the border of the opening or the sealing device. Thus, the operating parameters for igniting and maintaining the plasma during the deposition of the at least one PVD layer can be chosen freer without risking any damaging of the apparatus.

Alternatively, however, the minimal opening diameter is the same as the minimal sputter target diameter of the sputter target or even smaller than the minimal sputter target diameter.

Preferably, the apparatus is adapted such that in the physical vapour deposition configuration, during depositing the at least one PVD layer, the distance between the substrate holder and the means for depositing the at least one PVD layer is larger than a height above the sputter target of a plasma sheath produced during sputter depositing the at least one PVD layer with the sputter source. This has the advantage that the substrate holder is not damaged by the plasma sheath since the plasma sheath does not reach the substrate holder. This has the advantage that the substrate is not damaged by the plasma sheath since the plasma sheath does not reach the substrate holder.

In case the apparatus includes the control unit, the control unit is advantageously adapted to control the apparatus such that in the physical vapour deposition configuration, during depositing the at least one PVD layer, the distance between the substrate holder and the means for depositing the at least one PVD layer is larger than the height above the sputter target of the plasma sheath produced during sputter depositing the at least one PVD layer with the sputter source. Thereby, the control unit is advantageously adapted to control the sputter source to produce the plasma sheath to have the height above the sputter target during sputter depositing the at least one PVD layer with the sputter source being smaller than the distance between the substrate holder and the means for depositing the at least one PVD layer.

In a preferred variant, the apparatus is adapted such that in the physical vapour deposition configuration, during depositing the at least one PVD layer, the distance between the substrate held in the substrate holder and the means for depositing the at least one PVD layer is larger than the height above the sputter target of a plasma sheath produced during sputter depositing the at least one PVD layer with the sputter source. This has the advantage that the substrate and any material layer already deposited on the substrate is not damaged by the plasma sheath since the plasma sheath does not reach the substrate. In case the apparatus includes the control unit, the control unit is advantageously adapted to control the apparatus such that in the physical vapour deposition configuration, during depositing the at least one PVD layer, the distance between the substrate held in the substrate holder and the means for depositing the at least one PVD layer is larger than the height above the sputter target of the plasma sheath produced during sputter depositing the at least one PVD layer with the sputter source. Thereby, the control unit is advantageously adapted to control the sputter source to produce the plasma sheath to have the height above the sputter target during sputter depositing the at least one PVD layer with the sputter source being smaller than the distance between the substrate held in the substrate holder and the means for depositing the at least one PVD layer.

As an alternative, the apparatus is adapted such that in the physical vapour deposition configuration, during depositing the at least one PVD layer, the distance between the substrate and the means for depositing the at least one PVD layer and/or the distance between the substrate holder and the means for depositing the at least one PVD layer is not larger than the height above the sputter target of a plasma sheath produced during sputter depositing the at least one PVD layer with the sputter source.

Preferably, the apparatus is adapted such that in the physical vapour deposition configuration, during depositing the at least one PVD layer, the plasma sheath produced during sputter depositing the at least one PVD layer with the sputter source reaches from the sputter target at least into the opening. Thereby, the plasma sheath reaching from the sputter target at least into the opening means that the plasma sheath can reach into the opening or even through the opening to the side of the opening opposite of the side of the opening where the sputter target is located. The plasma sheath produced during sputter depositing the at least one PVD layer with the sputter source reaching from the sputter target at least into the opening has the advantage that in the physical vapour deposition configuration, the distance between the substrate holder and the means for depositing the at least one PVD layer by physical vapour deposition can easily be maintained smaller than the minimal opening diameter. For example, even in case the substrate holder is in the physical vapour deposition configuration and in the chemical vapour deposition configuration at the same position, this enables maintaining this distance smaller than the minimal opening diameter. Furthermore, the plasma sheath produced during sputter depositing the at least one PVD layer with the sputter source reaching from the sputter target at least into the opening has the advantage that in case the substrate surface on which the at least on PVD layer is to be deposited is larger than the aperture of the opening, it is easier to deposit very homogeneous PVD layers having a uniform thickness because it is easier to produce a cloud of evaporated material of the sputter target, the cloud being uniform along the surface of the substrate on which the at least on PVD layer is to be deposited.

In case the apparatus includes the control unit, the control unit is advantageously adapted to control the apparatus such that in the physical vapour deposition configuration, during depositing the at least one PVD layer, the plasma sheath produced during sputter depositing the at least one PVD layer with the sputter source reaches from the sputter target at least into the opening. Thereby, the control unit is advantageously adapted to control the sputter source to produce the plasma sheath to reach from the sputter target at least into the opening during sputter depositing the at least one PVD layer with the sputter source. Thereby, again, the plasma sheath reaching from the sputter target at least into the opening means that the plasma sheath can reach into the opening or even through the opening to the side of the opening opposite of the side of the opening where the sputter target is located.

As an alternative to these variants, the means for depositing the at least one PVD layer by physical vapour deposition on the substrate goes without a sputter source for sputter depositing the at least one PVD layer by sputtering sputter target material from a sputter target, wherein the distance between the substrate holder and the means for depositing the at least one PVD layer by physical vapour deposition is the distance between the substrate holder and the sputter source. In one such alternative, the means for depositing the at least one PVD layer includes a heatable source for evaporating a target material from a target for depositing the at least one PVD layer. In another such alternative, the means for depositing the at least one PVD layer includes an electron beam source for generating and directing an electron beam onto a target to vaporise the target material from the target for depositing the at least one PVD layer. Yet another example for the means for depositing the at least one PVD layer includes a laser for generating a laser beam to be directed on a target to vaporise the target material from the target for depositing the at least one PVD layer.

Advantageously, in the physical vapour deposition configuration, the means for depositing the at least one PVD layer by physical vapour deposition is arranged at least partially, in particular fully, in the physical vapour deposition chamber. This has the advantage that the apparatus can be constructed simpler because the means for depositing the at least one PVD layer by physical vapour deposition is not required to be moved out of the physical vapour deposition chamber for depositing the at least one PVD layer.

Alternatively, however, in the physical vapour deposition configuration, the means for depositing the at least one PVD layer by physical vapour deposition is arranged outside of the physical vapour deposition chamber, in particular in the chemical vapour deposition chamber. Such an alternative has the advantage that in the physical vapour deposition configuration, the distance between the substrate holder and the means for depositing the at least one PVD layer by physical vapour deposition can easily be maintained smaller than the minimal opening diameter. For example, even in case the substrate holder is in the physical vapour deposition configuration and in the chemical vapour deposition configuration at the same position, this enables maintaining this distance smaller than the minimal opening diameter. Furthermore, this has the advantage that in case the substrate surface on which the at least on PVD layer is to be deposited is larger than the aperture of the opening, it is easier to deposit very homogeneous PVD layers having a uniform thickness because it is easier to produce a cloud of evaporated material of the sputter target, the cloud being uniform along the surface of the substrate on which the at least on PVD layer is to be deposited.

Preferably, in the physical vapour deposition configuration and in the chemical vapour deposition configuration, the means for depositing the at least one PVD layer by physical vapour deposition is arranged at a same position in the physical vapour deposition chamber. This has the advantage that the apparatus can be constructed simpler and in a more cost effective way because the means for depositing the at least one PVD layer by physical vapour deposition is not required to be repositioned when switching the apparatus from the physical vapour deposition configuration to the chemical vapour deposition configuration and back. Thereby, it is irrelevant whether the means for depositing the at least one PVD layer by physical vapour deposition or a part of the means for depositing the at least one PVD layer by physical vapour deposition is rotatable around a PVD means axis or not. For example, in case the means for depositing the at least one PVD layer by physical vapour deposition includes a sputter source including a magnetron on which the sputter target is mounted, the sputter target or even the magnetron together with the sputter target may by rotatable around the PVD means axis during sputter depositing the at least one PVD layer while being arranged at a same position in the physical vapour deposition configuration and in the chemical vapour deposition configuration.

In case the means for depositing the at least one PVD layer by physical vapour deposition or a part of the means for depositing the at least one PVD layer by physical vapour deposition is rotatable around the PVD means axis, the apparatus advantageously includes an actuator for actuating the rotation of the means for depositing the at least one PVD layer by physical vapour deposition or the part of the means for depositing the at least one PVD layer by physical vapour deposition around the PVD means axis.

As an alternative to these variants, however, the means for depositing the at least one PVD layer by physical vapour deposition is arranged at a different position in the physical vapour deposition configuration than in the chemical vapour deposition configuration. For example, the means for depositing the at least one PVD layer by physical vapour deposition can be arranged in the physical vapour deposition configuration at a different position in the physical vapour deposition chamber as compared to in the chemical vapour deposition configuration. In one example, in the physical vapour deposition configuration, the means for depositing the at least one PVD layer by physical vapour deposition is arranged in the physical vapour deposition chamber closer to the opening as compared to in the chemical vapour deposition configuration.

In case the apparatus is adapted such that in the physical vapour deposition configuration, during depositing the at least one PVD layer, the plasma sheath produced during sputter depositing the at least one PVD layer with the sputter source reaches from the sputter target at least into the opening, the apparatus is advantageously adapted such that in the physical vapour deposition configuration, the sealing device is in the unsealing state. In case the apparatus thereby includes the control unit, the control unit is advantageously adapted to prevent producing the plasma sheath and thus adapted to prevent any sputter deposition with the sputter source whenever the sealing device is in the sealing state. This has the advantage that damages of the sealing device caused by the plasma sheath touching the sealing device in the sealing state are prevented. Thereby, in case a presputtering of the sputter target is effected in order to clean the surface of the sputter target before the at least one PVD layer is deposited, the sealing device is advantageously in the unsealing state during the presputtering. Thereby, the apparatus advantageously includes a shutter for covering the sputter target during the presputtering. Such shutters are known in the art. They are switched to a cover state for covering the sputter target during presputtering and are switched to an uncover state for depositing the at least one PVD layer. However, the apparatus may as well go without such a shutter.

In case a presputtering of the sputter target is effected in order to clean the surface of the sputter target before the at least one PVD layer is deposited while the sealing device is in the sealing state, for the presputtering, the sputter target is advantageously arranged at a distance from the sealing device being larger than the height of the plasma sheath above the sputter target. In this case, the apparatus may go without the above mentioned shutter. For example, this presputtering can be effected with the sealing device in the sealing state and with the sputter source at a position in the PVD chamber at which position the sputter source is arranged when the apparatus is in the chemical vapour deposition configuration.

In a variant, however, despite the apparatus being adapted such that in the physical vapour deposition configuration, during depositing the at least one PVD layer, the plasma sheath produced during sputter depositing the at least one PVD layer with the sputter source reaches from the sputter target at least into the opening, the apparatus goes without being adapted such that in the physical vapour deposition configuration, the sealing device is in the unsealing state.

Independent of whether the apparatus is adapted such that in the physical vapour deposition configuration, during depositing the at least one PVD layer, the plasma sheath produced during sputter depositing the at least one PVD layer with the sputter source reaches from the sputter target at least into the opening, or not, in the physical vapour deposition configuration, the sealing device is advantageously in the unsealing state. This has the advantage that in the physical vapour deposition configuration, an efficient deposition of the at least one PVD layer is enabled because it is not required to transfer the substrate holder with the substrate into the physical vapour deposition chamber and subsequently switching the sealing device to the sealing state when switching the apparatus from the chemical vapour deposition configuration to the physical vapour deposition configuration. Furthermore, it is not required to switch the sealing device first to the unsealing state and subsequently transfer the substrate holder with the substrate back into the chemical vapour deposition chamber when switching the apparatus from the physical vapour deposition configuration to the chemical vapour deposition configuration. Thus, the material layers can be deposited faster and more efficiently on the substrate.

As an alternative, however, the in the physical vapour deposition configuration, the sealing device is not in the unsealing state. In such an alternative, in the physical vapour deposition configuration, the sealing device is advantageously in the sealing state.

Preferably, in the chemical vapour deposition configuration, the sealing device is in the sealing state. This has the advantage that in the chemical vapour deposition configuration, the chemical vapour deposition chamber is isolated from the physical vapour deposition chamber. Thus, the volume of the chemical vapour deposition chamber is isolated from the volume of the physical vapour deposition chamber. Consequently, during chemical vapour deposition in the chemical vapour deposition configuration, contaminations cannot reach from the physical vapour deposition chamber into the chemical vapour deposition chamber. Therefore, the quality of the at least one CVD layer deposited with chemical vapour deposition can be improved. Furthermore, during chemical vapour deposition in the chemical vapour deposition configuration, contaminations due to the volatile precursors used for depositing the at least one CVD layer on the substrate cannot reach from the chemical vapour deposition chamber into the physical vapour deposition chamber. Therefore, the physical vapour deposition chamber is kept cleaner, thus enabling a cleaner physical vapour deposition process resulting in an improved quality of the deposited at least one PVD layer during any subsequent physical vapour deposition. This is advantage is particular advantageous in case sputtering is used as physical vapour deposition. Furthermore, due to the isolation of the chemical vapour deposition chamber from the physical vapour deposition chamber in the chemical vapour deposition configuration, the volume in which the volatile precursors used for depositing the at least one CVD layer on the substrate are provided is smaller. Consequently, the at least one CVD layer can be deposited more efficiently.

In an alternative, however, in the chemical vapour deposition configuration, the sealing device is not in the sealing state. In such an alternative, in the chemical vapour deposition configuration, the sealing device is advantageously in the unsealing state.

Advantageously, in the chemical vapour deposition configuration, the means for depositing the at least one CVD layer by chemical vapour deposition is arranged in the chemical vapour deposition chamber. This has the advantage that the at least one CVD layer can be deposited in an efficient manner. In a particular advantageous variant, the means for depositing the at least one CVD layer by chemical vapour deposition is permanently arranged, in particular at a fixed position, in the chemical vapour deposition chamber. This has the additional advantage that the apparatus can be constructed more simple and reliable because the means for depositing the at least one CVD layer by chemical vapour deposition is not needed to be moved and this movement is not needed to be actuated. In a variant, however, the means for depositing the at least one CVD layer by chemical vapour deposition is not permanently arranged in the chemical vapour deposition chamber.

Preferably, the means for depositing the at least one CVD layer by chemical vapour deposition includes at least one precursor inlet, more preferably at least two precursor inlets, for introducing gas precursors into the chemical vapour deposition chamber in a controlled way, wherein chemical reactions of the gas precursors are leading to a surface deposition and thus to the deposition of the at least one CVD layer. This has the advantage that the at least one CVD layer can be deposited in a very efficient manner.

Alternatively, however, the means for depositing the at least one CVD layer by chemical vapour deposition goes without precursor inlet for introducing gas precursors into the chemical vapour deposition chamber in a controlled way.

Preferably, in the physical vapour deposition configuration and in the chemical vapour deposition configuration, the substrate holder is arranged at a same position in the chemical vapour deposition chamber. This has the advantage that the apparatus can be constructed simpler and more cost effective. Thereby, it is irrelevant whether the entire substrate holder or a part of is the substrate holder is rotatable around a substrate holder axis for rotating the substrate during deposition of the at least one CVD layer and/or during deposition of the at least one PVD layer or not. In case the entire substrate holder or a part of is the substrate holder is rotatable around a substrate holder axis for rotating the substrate during deposition of the at least one CVD layer and/or during deposition of the at least one PVD layer, the apparatus advantageously includes an actuator for actuating this rotation of the substrate holder around the substrate holder axis.

In a preferred variant, however, in the physical vapour deposition configuration, the substrate holder is arranged at a different position than in the chemical vapour deposition configuration. Particular advantageously, in the physical vapour deposition configuration, the substrate holder is arranged at a different position in the chemical vapour deposition chamber as compared to in the chemical vapour deposition configuration. In one example, in the physical vapour deposition configuration, the substrate holder is arranged in the chemical vapour deposition chamber closer to the opening as compared to in the chemical vapour deposition configuration.

In order to achieve this, the substrate holder is advantageously movable along a linear axis. Thereby, in the chemical vapour deposition configuration, the substrate holder is advantageously in a CVD position, and in the physical vapour deposition configuration, the substrate holder is advantageously in a PVD position. Thereby, in the PVD position, the substrate holder is advantageously arranged closer to the opening than in the CVD position. Furthermore, in the CVD position, the substrate holder is advantageously located in the chemical vapour deposition camber. In a first variant, in the PVD position, the substrate holder is located in the chemical vapour deposition chamber, too. In a second variant, in the PVD position, the substrate holder is located in the opening. In a third variant, in the PVD position, the substrate holder is located in the physical vapour deposition chamber. In all these variants, the substrate holder is advantageously moveable from the CVD position to the PVD position and back. In case the apparatus includes the control unit, the movement of the substrate holder from the CVD position to the PVD position and back is advantageously controllable by the control unit.

Preferably, the substrate holder is rotatable around the substrate holder axis for rotating the substrate held in the substrate holder around the axis during deposition of said at least one CVD layer and/or during deposition of said at least one PVD layer. This has the advantage that more homogeneous CVD layers and/or PVD layers can be deposited.

In a preferred variant, the apparatus includes an actuator for actuating the rotation of the substrate holder with the substrate around the substrate holder axis during deposition of said at least one CVD layer and/or during deposition of said at least one PVD layer. The apparatus may however as well go without such an actuator.

Alternatively, however, the substrate holder is not rotatable around the substrate holder axis for rotating the substrate around the axis during deposition of said at least one CVD layer or during deposition of said at least one PVD layer.

Advantageously, the sealing device is a gate valve providing a closed state being the sealing state and an open state being the unsealing state. Thereby, a gate valve can also be referred to as a sluice valve. A gate valve or sluice valve is advantageously a valve that opens to the open state by moving a barrier, which can also be referred to as a gate, out of the path of a fluid. In the present case, this fluid is the gas in the chemical vapour deposition chamber and the physical vapour deposition chamber. Gate valves require very little space along a direction perpendicular to the barrier or gate, along which direction the fluid can move through the gate valve in case the gate valve is in the open state. In the open state, gate valves hardly restrict the flow of fluid when the gate is fully opened and thus in the open state, while in the closed state, they prevent the flow of the fluid through the gate valve. The faces of the gate of a gate valve can be parallel but are most commonly wedge-shaped in order to be able to apply pressure on the sealing surface in the closed state of the gate valve in order to seal the opening of the gate valve better.

Advantageously, the sealing device, in particular the gate valve, is arranged between the chemical vapour deposition chamber and the physical vapour deposition chamber. This has the advantage that the chemical vapour deposition chamber can be isolated from the physical vapour deposition chamber by sealing the opening very easily be switching the sealing device to the sealing state and that the isolation of the chemical vapour deposition chamber from the physical vapour deposition chamber can be easily revoked by switching the sealing device to the unsealing state.

Alternatively, however, the gate valve is not arranged between the chemical vapour deposition chamber and the physical vapour deposition chamber.

Advantageously, the chemical vapour deposition chamber includes a CVD vacuum port for being connected to a CVD vacuum generating arrangement for obtaining a reduced pressure inside the chemical vapour deposition chamber, in particular in the chemical vapour deposition configuration. Thereby, the CVD vacuum generating arrangement can for example be a vacuum pump or a vacuum system of a laboratory building. In an advantageous variant, the apparatus includes the CVD vacuum generating arrangement. Independent of whether the apparatus includes the CVD vacuum generating arrangement or not, the chemical vapour deposition chamber is advantageously adapted for being operated, in particular in the chemical vapour deposition configuration, at a pressure of less than 10⁻² mbar, particular advantageously less than 10⁻³ mbar, for chemical vapour deposition of the at least one CVD layer. In case the apparatus includes the CVD vacuum generating arrangement, the CVD vacuum generating arrangement is advantageously adapted for operating the chemical vapour deposition chamber, in particular in the chemical vapour deposition configuration, at a pressure of less than 10⁻² mbar, particular advantageously less than 10⁻³ mbar for chemical vapour deposition of the at least one CVD layer. This low pressure in the chemical vapour deposition chamber can for example be achieved in the chemical vapour deposition configuration before the deposition of the at least one CVD layer is started. Once a volatile precursor, in particular a gas precursor is introduced into the chemical vapour deposition chamber for depositing the at least one CVD layer, the pressure in the chemical vapour deposition chamber may for example rise to about 10⁻¹ mbar or even to about 1 mbar.

Advantageously, a connection line from the chemical vapour deposition chamber via the CVD vacuum port to the CVD vacuum generating arrangement for obtaining the reduced pressure inside the chemical vapour deposition chamber provides a first valve for closing this connection line in the physical vapour deposition configuration such that process gases and evaporated material in the chemical vapour deposition chamber cannot reach to the CVD vacuum generating arrangement. This has the advantage that the CVD vacuum generating arrangement can be protected when the apparatus is in the physical vapour deposition configuration. Advantageously, this first valve is arranged in the CVD vacuum port. Alternatively, however, the apparatus may go without such a first valve.

However, the apparatus can go without the CVD vacuum generating arrangement. For example, the apparatus can be sold without the CVD vacuum generating arrangement in case the apparatus is to be employed in a building providing a vacuum system or in case any other suitable CVD vacuum generating arrangement like a suitable vacuum pump is available already.

Alternatively to these variants, the chemical vapour deposition chamber is not adapted for being operated, in particular in the chemical vapour deposition configuration, at a pressure of less than 10⁻² mbar for chemical vapour deposition of the at least one CVD layer.

Advantageously, the chemical vapour deposition chamber and/or the physical vapour deposition chamber, particular advantageously the physical vapour deposition chamber, includes a PVD vacuum port for being connected to a PVD vacuum generating arrangement for obtaining a reduced pressure inside the physical vapour deposition chamber, in particular in the physical vapour deposition configuration. Thereby, in case the sealing device is in the unsealing state in the physical vapour deposition configuration, the PVD vacuum port is for being connected to the PVD vacuum generating arrangement for obtaining a reduced pressure inside the chemical vapour deposition chamber and the physical vapour deposition chamber, in particular in the physical vapour deposition configuration. In either case, the PVD vacuum generating arrangement can for example be a vacuum pump or a vacuum system of a laboratory building. Advantageously, the apparatus includes the PVD vacuum generating arrangement. Independent of whether the apparatus includes the PVD vacuum generating arrangement or not, the physical vapour deposition chamber is advantageously adapted for being operated, in particular in the physical vapour deposition configuration, at a pressure of less than 10⁻⁷ mbar, particular advantageously less than 10⁻⁸ mbar for physical vapour depositing the at least one PVD layer. This low pressure in the physical vapour deposition chamber can for example be achieved in the physical vapour deposition configuration before the deposition of the at least one PVD layer is started. Once a plasma gas is introduced into the physical vapour deposition chamber for generating therefrom a plasma for depositing the at least one PVD layer, the pressure in the physical vapour deposition chamber may for example rise to about 10⁻² mbar.

In case the sealing device is in the unsealing state in the physical vapour deposition configuration, the physical vapour deposition chamber and the chemical vapour deposition chamber are advantageously adapted for being operated, in particular in the physical vapour deposition configuration, at a pressure of less than 10⁻⁷ mbar, particular advantageously less than 10⁻⁸ mbar for physical vapour depositing said at least one PVD layer. In case the apparatus includes the PVD vacuum generating arrangement, the PVD vacuum generating arrangement is advantageously adapted for operating the physical vapour deposition chamber, in particular in the physical vapour deposition configuration, at a pressure of less than 10⁻⁷ mbar, particular advantageously less than 10⁻⁸ mbar. In case the sealing device is in the unsealing state in the physical vapour deposition configuration, the PVD vacuum generating arrangement is advantageously adapted for operating the chemical vapour deposition chamber and the physical vapour deposition chamber, in particular in the physical vapour deposition configuration, at a pressure of less than 10⁻⁷ mbar, particular advantageously less than 10⁻⁸ mbar.

Advantageously, a connection line from the physical vapour deposition chamber via the PVD vacuum port to the PVD vacuum generating arrangement for obtaining the reduced pressure inside the physical vapour deposition chamber provides a second valve for closing this connection line in the chemical vapour deposition configuration such that process gases and evaporated material in the physical vapour deposition chamber cannot reach to the PVD vacuum generating arrangement. This has the advantage that the PVD vacuum generating arrangement can be protected when the apparatus is in the chemical vapour deposition configuration. Advantageously, this second valve is arranged in the PVD vacuum port. Alternatively, however, the apparatus may go without such a second valve.

However, the apparatus can go without the PVD vacuum generating arrangement. For example, apparatus can be sold without the PVD vacuum generating arrangement in case the apparatus is to be employed in a building providing a vacuum system or in case any other suitable PVD vacuum generating arrangement like a suitable vacuum pump is available already.

Alternatively to these variants, the physical vapour deposition chamber is not adapted for being operated, in particular in the physical vapour deposition configuration, at a pressure of less than 10⁻⁷ mbar.

Advantageously, the sealing device is adapted for sealing the opening in the sealing state to maintain a pressure difference across the sealing device of at least a factor of 10'000. This has the advantage that the apparatus can be operated very efficiently for depositing at least one CVD layer and at least one PVD layer on the substrate. Particular advantageously, the sealing device is adapted for sealing the opening in the sealing state to maintain a pressure in the physical vapour deposition chamber which is at least 10'000 times less than a pressure in the chemical vapour deposition chamber. More advantageously, the sealing device is advantageously adapted for sealing the opening in the sealing state to maintain in the physical vapour deposition chamber a pressure which is less than 10⁻⁷ mbar when the pressure in the chemical vapour deposition chamber is about 10⁻³ mbar.

Alternatively, however, the sealing device is not adapted for sealing the opening in the sealing state to maintain a pressure difference across the sealing device of at least a factor of 10'000.

Other advantageous embodiments and combinations of features come out from the detailed description below and the entirety of the claims.

### Brief description of the drawings

The drawings used to explain the embodiments show:
- Fig. 1: an apparatus according to the invention for depositing material layers on a substrate with chemical vapour deposition and physical vapour deposition, the apparatus being shown in a chemical vapour deposition configuration,
- Fig. 2: the apparatus in a first variant of a physical vapour deposition configuration,
- Fig. 3: the apparatus in a second variant of a physical vapour deposition configuration,
- Fig. 4: the apparatus in a third variant of a physical vapour deposition configuration, and
- Fig. 5: the apparatus in a fifth variant of a physical vapour deposition configuration.

In the figures, the same components are given the same reference symbols.

### Preferred embodiments

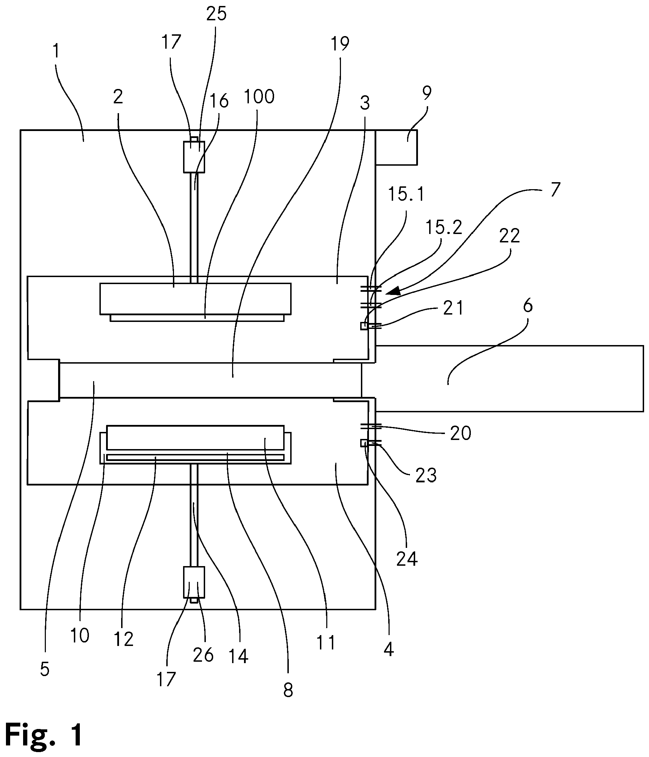

Figure 1 shows a simplified schematic view of an apparatus 1 according to the invention for depositing material layers on a substrate 100 with chemical vapour deposition and physical vapour deposition. More precisely, the apparatus 1 is for depositing material layers on the substrate 100 with atomic layer deposition, which is a type of chemical vapour deposition, and physical vapour deposition.

The apparatus 1 includes a substrate holder 2 for holding the substrate 100 during deposition of the material layers. Furthermore, the apparatus 1 includes a chemical vapour deposition chamber 3 and a physical vapour deposition chamber 4. Since the apparatus 1 is for depositing material layers on the substrate 100 with atomic layer deposition, the chemical vapour deposition chamber 3 can also be referred to as atomic layer deposition chamber.

The physical vapour deposition chamber 4 and the chemical vapour deposition chamber 3 are interconnected via an opening 5 having a minimal opening diameter. Thereby, the opening 5 forms an aperture having a circular shape. Since in Figure 1, a cross sectional view of the apparatus 1 is shown, the circular shape of the aperture is not visible. Rather, the width of the opening 5 measured horizontally in Figure 1 corresponds to the diameter of the aperture of the opening 5. Since the opening 5 forms an aperture having a circular shape, this diameter is at the same time the minimal opening diameter of the opening 5.

As visible in Figure 1, the apparatus 1 includes means 7 for depositing at least one ALD layer by atomic layer deposition on the substrate 100, each one of the at least one ALD layer being one of the material layers. Since atomic layer deposition is a type of chemical vapour deposition, an ALD layer is a CVD layer and the means 7 for depositing at least one ALD layer by atomic layer deposition on the substrate 100 is a means 7 for depositing at least one CVD layer by chemical vapour deposition on the substrate 100, each one of the at least one CVD layer being one of the material layers.

For depositing the at least one CVD layer with the means 7 for depositing the at least one CVD layer by chemical vapour deposition on the substrate 100, the apparatus 1 is switchable to a chemical vapour deposition configuration. In Figure 1, the apparatus 1 is shown in this chemical vapour deposition configuration.

The means 7 for depositing the at least one CVD layer by chemical vapour deposition includes two precursor inlets 15.1, 15.2, for introducing gas precursors into the chemical vapour deposition chamber 3 in a controlled way, wherein chemical reactions of the gas precursors are leading to a surface deposition and thus to the deposition of the at least one CVD layer. In order to provide the gas precursors, the two precursor inlets 15.1, 15.2 are each connectable or connected to a source of the respective gas precursor. Since the two precursor inlets 15.1, 15.2 are fixedly arranged in a sidewall of the chemical vapour deposition chamber 3, the means 7 for depositing the at least one CVD layer by chemical vapour deposition is permanently arranged at a fixed position in the chemical vapour deposition chamber 3.

The apparatus 1 further includes means 8 for depositing at least one PVD layer by physical vapour deposition on the substrate 100, each one of the at least one PVD layer being one of the material layers. The means 8 for depositing the at least one PVD layer by physical vapour deposition on the substrate 100 is a sputter source 10 for sputter depositing the at least one PVD layer by sputtering sputter target material from a sputter target 11 having a minimal sputter target diameter. Thereby, the sputter source 10 includes a magnetron 12. Without sputter target 11, the distance between the substrate holder 2 and the means 8 for depositing the at least one PVD layer by physical vapour deposition is the distance between the substrate holder 2 and the sputter source 10. In a variant where the sputter source 10 includes the sputter target 11, however, the means 8 for depositing the at least one PVD layer is the sputter source 10 including the sputter target 11. In this case, the distance between the substrate holder 2 and the means 8 for depositing the at least one PVD layer by physical vapour deposition is however the distance between the substrate holder 2 and the sputter target 11.

As mentioned already, the opening 5 provides an aperture defining an aperture plane. In Figure 1, this aperture plane is arranged horizontally and vertically to the plane of the illustration. When taking a cross section of the sputter target 11 in a plane parallel to the aperture plane, this cross section of the sputter target 11 has a circular shape due to the cylindrical shape and orientation of the sputter target 11. For this reason, a diameter of the cross section of the sputter target 11 is at the same time the minimal sputter target diameter of the sputter target 11. Thereby, the minimal opening diameter of the opening 5 is larger than the minimal sputter target diameter of the sputter target 11. Futhermore, when projecting the cross section of the sputter target 11 onto the aperture plane, the projection of the cross section of the sputter target 11 is located within the aperture of the opening 5. More precisely, the projection of the cross section of the sputter target 11 onto the aperture plane including a circumferential border around the projection having a width of 3 cm is located within the aperture of the opening 5. Thus, in this particular embodiment, the minimal opening diameter is 6 cm larger than the minimal sputter target diameter.

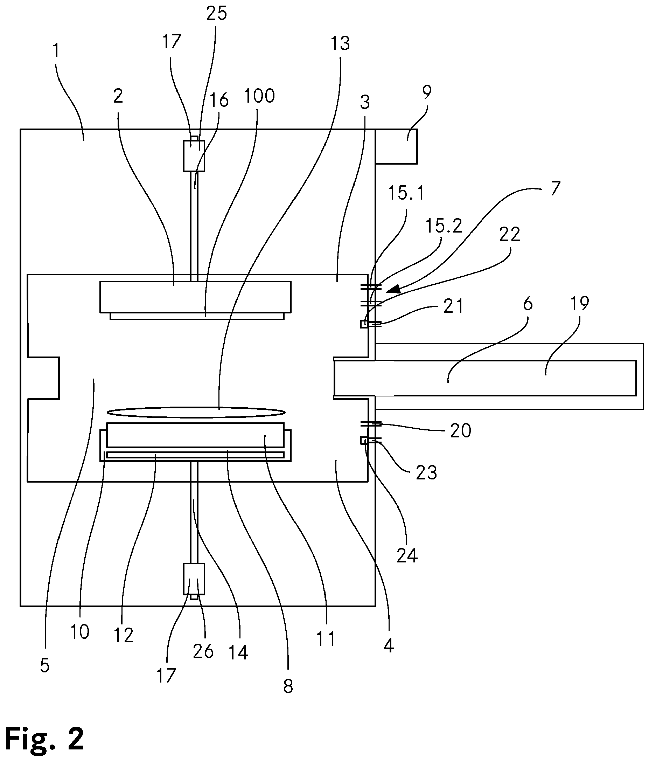

The apparatus 1 includes a sealing device 6 for isolating the chemical vapour deposition chamber 3 from the physical vapour deposition chamber 4 by sealing the opening 5. The sealing device 6 is switchable between a sealing state in which sealing state the chemical vapour deposition chamber 3 is isolated from the physical vapour deposition chamber 4 in that the opening 5 is sealed by the sealing device 5, and an unsealing state in which unsealing state the isolation of the chemical vapour deposition chamber 3 from the physical vapour deposition chamber 4 by the sealing device 6 is revoked. In the present embodiment, the sealing device 6 is a gate valve providing a closed state being the sealing state and an open state being the unsealing state. This gate valve opens to the open state by moving a gate 19, out of the path of the gas in the chemical vapour deposition chamber 3 and the physical vapour deposition chamber 4 as shown in the Figures 2, 3, 4 and 5. As shown in Figure 1, in the closed state, the gate 19 is covers the opening 5 such that the gate valve prevents the flow of the gas through the gate valve and through the opening 5.

The chemical vapour deposition chamber 3 and the physical vapour deposition chamber 4 are arranged on opposite sides of the sealing device 6. Thus, the sealing device 6, which is in the present embodiment the gate valve, is arranged between the chemical vapour deposition chamber 3 and the physical vapour deposition chamber 4.

In Figure 1, the apparatus 1 is shown in the chemical vapour deposition configuration. In this configuration, the sealing device 6 is in the sealing state. Thus, in Figure 1, the chemical vapour deposition chamber 3 is isolated from the physical vapour deposition chamber 4 in that the opening 5 is sealed with the sealing device 6.

In order to deposit the at least one PVD layer, the apparatus 1 is switchable from the chemical vapour deposition configuration shown in Figure 1 to a physical vapour deposition configuration for depositing the at least one PVD layer with the means 8 for depositing the at least one PVD layer by physical vapour deposition on the substrate 100. In this physical vapour deposition configuration, the sealing device 6 is in the unsealing state and the isolation of the chemical vapour deposition chamber 3 from the physical vapour deposition chamber 4 by the sealing device 6 is revoked. Apart from the sealing device 6 being in the unsealing state when the apparatus 1 is in the physical vapour deposition configuration, there are different settings for the substrate holder 2 and the means 8 for depositing the at least one PVD layer possible in the physical vapour deposition configuration. For this reason, the Figures 2, 3, 4 and 5 each show another variant of the physical vapour deposition configuration. In one example, the apparatus 1 enables all these variants of the physical vapour deposition configuration. In this example, the apparatus 1 is switchable in each one of these four variants of the physical vapour deposition configuration. In order to illustrate this example, the Figures 2, 3, 4 and 5 all relate to the apparatus 1 and use the same reference numbers. However, the apparatus 1 may not enable one, two or three of the four variants shown in the Figures 2, 3, 4 and 5. Thus, for example, the apparatus enables only one of these four variants of the physical vapour deposition configuration. In another example, the apparatus enables two of these four variants of the physical vapour deposition configuration. In yet another example, the apparatus enables three of these four variants of the physical vapour deposition configuration.

In all variants of the physical vapour deposition configuration, a distance between the substrate holder 2 and the means 8 for depositing the at least one PVD layer by physical vapour deposition is smaller than the minimal opening diameter. As well, in the physical vapour deposition configuration, a distance between the substrate 100 held in the substrate holder 2 and the means 8 for depositing said at least one PVD layer by physical vapour deposition is smaller than the minimal opening diameter. In one example, the distance between the substrate holder 2 and the means 8 for depositing the at least one PVD layer by physical vapour deposition is 29 cm. In another example, this distance is 19 cm. In yet another example, this distance is 9 cm. In yet another example, this distance is 5.5 cm. In yet another example, this distance is 4.5 cm. In yet another example, this distance is 3.5 cm. In yet another example, this distance is 2.3 cm. Thereby, since the substrate 100 held in the substrate holder 2 provides a thickness of 0.2 cm, the distance between the substrate held in the substrate holder 2 and the means 8 for depositing the at least one PVD layer by physical vapour deposition is in each of these variants 0.2 cm less than the indicated distance between the substrate holder 2 and the means 8 for depositing the at least one PVD layer by physical vapour deposition.

The apparatus 1 provides a plasma gas inlet 20 for inserting argon as plasma gas into the physical vapour deposition chamber 4. This plasma gas inlet 20 is connectable or connected to a plasma gas source. In the present embodiment, this plasma gas source is a bottle of argon gas. During deposition of the at least one PVD layer by physical vapour deposition, charged plasma particles formed from the plasma gas are confined close to the surface of the sputter target 11 by strong electric and magnetic fields generated with the magnetron 12. The area containing this increased concentration of the charged plasma particles is referred to as the plasma sheath. In Figures 2, 3, 4 and 5, this plasma sheath 13 is shown. Thereby, the apparatus 1 is adapted such that in the physical vapour deposition configuration, during depositing the at least one PVD layer, the distance between the substrate holder 2 and the means 8 for depositing the at least one PVD layer is larger than a height above the sputter target 11 of this plasma sheath 13 produced during sputter depositing the at least one PVD layer with the sputter source 10. Even more, the apparatus 1 is adapted such that in the physical vapour deposition configuration, during depositing the at least one PVD layer, the distance between the substrate 100 held in the substrate holder 2 and the means 8 for depositing the at least one PVD layer is larger than a height above the sputter target 11 of this plasma sheath 13 produced during sputter depositing the at least one PVD layer with the sputter source 10.

As shown in Figures 1 to 5, the apparatus 1 furthermore includes a control unit 9 for controlling the apparatus 1 for depositing the material layers on the substrate 100 with chemical vapour deposition and physical vapour deposition. Thus, the control unit 9 is adapted for controlling the means 7 for depositing the at least one CVD layer by chemical vapour deposition, in the present embodiment by atomic layer deposition, on the substrate 100. Furthermore, the control unit 9 is adapted for controlling the means 8 for depositing the at least one PVD layer by physical vapour deposition on the substrate 100.

Additionally, the control unit 9 is adapted to switch the apparatus 1 to the chemical vapour deposition configuration for depositing the at least one CVD layer by chemical vapour deposition, in particular by atomic vapour deposition, and to switch the apparatus 1 to the physical vapour deposition configuration for depositing the at least one PVD layer by physical vapour deposition.

The control unit 9 is furthermore adapted to control the apparatus 1 such that in the physical vapour deposition configuration, during depositing the at least one PVD layer, the distance between the substrate 100 held in the substrate holder 2 and the means for depositing the at least one PVD layer is larger than the height above the sputter target 11 of the plasma sheath 13 produced during sputter depositing the at least one PVD layer with the sputter source 10. Thereby, the control unit 9 is adapted to control the sputter source 10 to produce the plasma sheath 13 to have the height above the sputter target 11 during sputter depositing the at least one PVD layer with the sputter source 10 being smaller than the distance between substrate 100 held in the substrate holder 2 and the means for depositing the at least one PVD layer. Since the substrate 100 is 0.2 cm thick the control unit 9 is thus as well adapted to control the apparatus 1 such that in the physical vapour deposition configuration, during depositing the at least one PVD layer, the distance between the substrate holder 2 and the means 8 for depositing the at least one PVD layer is larger than the height above the sputter target 11 of the plasma sheath 13 produced during sputter depositing the at least one PVD layer with the sputter source 10. Thereby, the control unit 9 is as well adapted to control the sputter source 10 to produce the plasma sheath to have the height above the sputter target 11 during sputter depositing the at least one PVD layer with the sputter source 10 being smaller than the distance between the substrate holder 2 and the means for depositing the at least one PVD layer.

As mentioned, in Figure 1, the apparatus 1 is shown in the chemical vapour deposition configuration. In the Figures 2, 3, 4 and 5, however, the apparatus 1 is shown in different variants of the physical vapour deposition configuration. Thereby, each one of the Figures 2, 3, 4 and 5 shows the apparatus 1 in another variant in the physical vapour deposition configuration. These variants of the physical vapour deposition configuration have in common that the magnetron 12 together with the sputter target 11 are by rotatable around the PVD means axis 14 during sputter depositing the at least one PVD layer. Thereby, the apparatus 1 includes an actuator 18 for actuating the rotation of the means 8 for depositing the at least one PVD layer by physical vapour deposition around the PVD means axis 14.

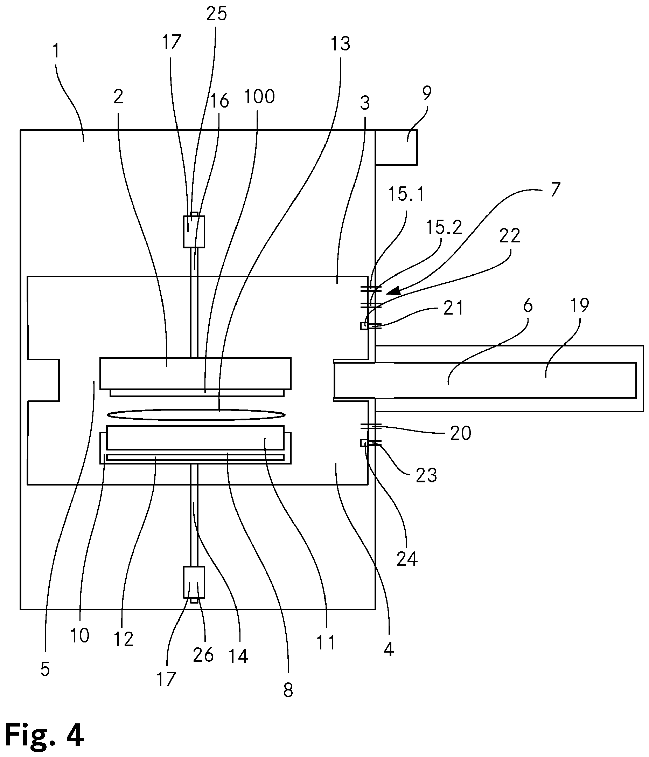

In Figures 2, 3 and 4, in the physical vapour deposition configuration, the means 8 for depositing the at least one PVD layer by physical vapour deposition is arranged at least partially, in particular fully, in the physical vapour deposition chamber 4. More precisely, in the variants shown in Figures 2 and 4, the means 8 for depositing the at least one PVD layer by physical vapour deposition is arranged at a same position in the physical vapour deposition chamber 4 as in the chemical vapour deposition configuration. Thus, in the variants shown in Figures 2 and 4, in the physical vapour deposition configuration and in the chemical vapour deposition configuration, the means 8 for depositing the at least one PVD layer by physical vapour deposition is arranged at a same position in the physical vapour deposition chamber 4. In these two variants, in the physical vapour deposition configuration, the means 8 for depositing the at least one PVD layer by physical vapour deposition is arranged fully in the physical vapour deposition chamber 4.

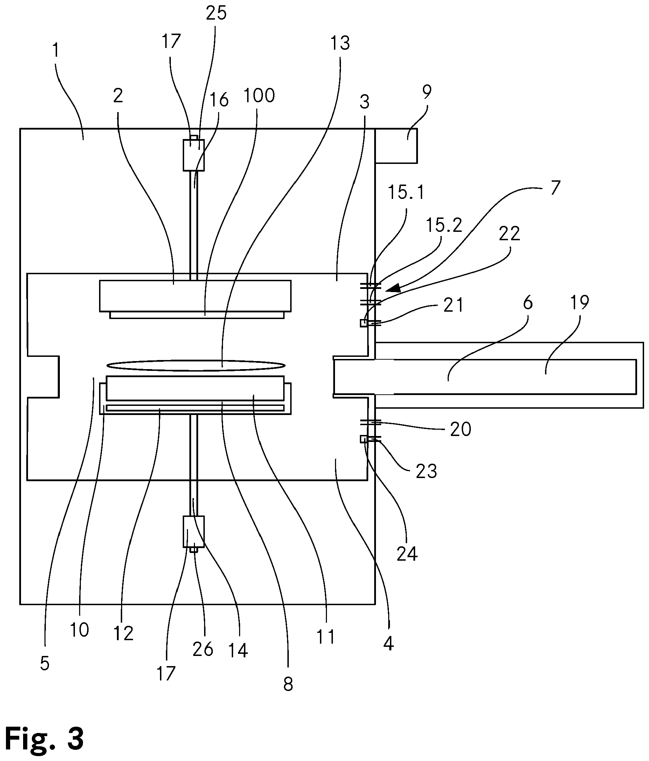

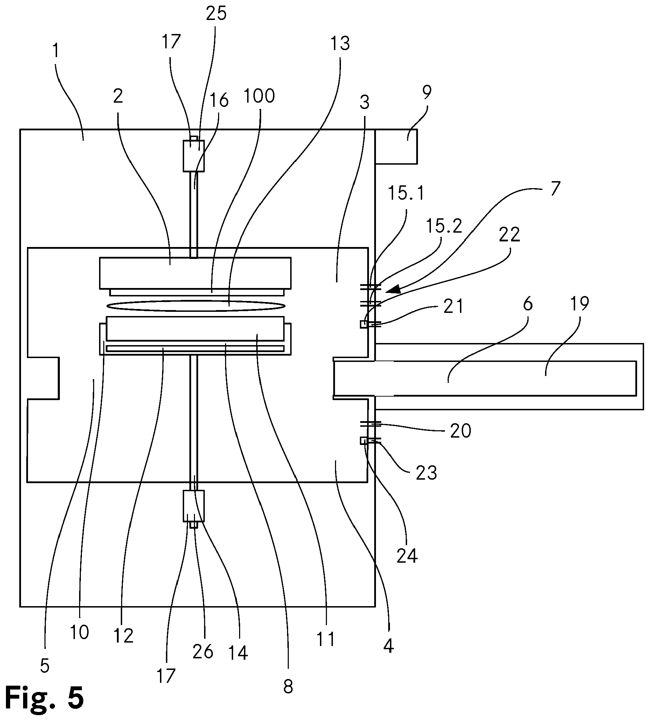

In contrast to the variants shown in Figures 2 and 4, in Figures 3 and 5, in the physical vapour deposition configuration, the means 8 for depositing the at least one PVD layer by physical vapour deposition is arranged at a different position as compared to in the chemical vapour deposition configuration. In the variant of Figure 3, in the physical vapour deposition configuration, the means 8 for depositing the at least one PVD layer by physical vapour deposition is arranged partially in the physical vapour deposition chamber 4. In the variant shown in Figure 5, however, in the physical vapour deposition configuration, the means 8 for depositing the at least one PVD layer by physical vapour deposition is arranged outside of the physical vapour deposition chamber 4. More precisely, in the variant of the physical vapour deposition configuration shown in Figure 5, the means 8 for depositing the at least one PVD layer by physical vapour deposition is arranged in the chemical vapour deposition chamber 3. Thus, in order to enable the variants of the physical vapour deposition configuration shown in Figures 3 and 5, the means 8 for depositing the at least one PVD layer by physical vapour deposition is moveable from a CVD position in the chemical vapour deposition configuration to a PVD position in the physical vapour deposition configuration and back. In order to actuate this movement of the means 8 for depositing the at least one PVD layer by physical vapour deposition, the apparatus 1 includes an actuator 26. This actuator 26 may be a linear motor which moves the means 8 for depositing the at least one PVD layer by physical vapour deposition along a straight line from the CVD position to the PVD position and back. Thereby, the actuator 26 and thus the movement of the means 8 for depositing the at least one PVD layer by physical vapour deposition along the straight line from the CVD position to the PVD position and back is controllable by the control unit 9.

In order to enable the variant shown in Figure 3, the apparatus 1 is adapted such that in the physical vapour deposition configuration, during depositing the at least one PVD layer, the plasma sheath 13 produced during sputter depositing the at least one PVD layer with the sputter source 10 reaches from the sputter target 11 at least into the opening 5. More precisely, the control unit 9 is adapted to control the sputter source 10 to produce the plasma sheath 13 to reach from the sputter target 11 at least into the opening 5 during sputter depositing the at least one PVD layer with the sputter source 10. Thereby, the plasma sheath 13 reaching from the sputter target 11 at least into the opening 5 means that the plasma sheath 13 can reach into the opening 5 or even through the opening 5 to the side of the opening 5 opposite of the side of the opening 5 where the sputter target 11 is located.

In order to enable the variant shown in Figures 5, the apparatus 1 is adapted such that in the physical vapour deposition configuration, during depositing the at least one PVD layer, the sputter target 1 is completely inside of the chemical vapour deposition chamber 3. Thus, the plasma sheath 13 produced during sputter depositing the at least one PVD layer with the sputter source 10 is located completely inside the chemical vapour deposition chamber 3.

In the variants shown in Figures 2, 3 and 5, the substrate holder 2 is arranged at a same position in the chemical vapour deposition chamber 3 in the physical vapour deposition configuration and in the chemical vapour deposition configuration.

In the variant shown in Figure 4, however, in the physical vapour deposition configuration, the substrate holder 2 is arranged at a different position than in the chemical vapour deposition configuration. Thereby, in the physical vapour deposition configuration, the substrate holder 2 is arranged at a different position in the chemical vapour deposition chamber as compared to in the chemical vapour deposition configuration. In one example, in the physical vapour deposition configuration, the substrate holder 2 is arranged in the chemical vapour deposition chamber 3 closer to the opening 5 as compared to in the chemical vapour deposition configuration. In order to achieve this, the substrate holder 2 is movable along a linear axis. Thereby, in the chemical vapour deposition configuration, the substrate holder 2 is in a CVD position, and in the physical vapour deposition configuration, the substrate holder 2 is in a PVD position. Thereby, the CVD position of the substrate holder 2 differs from the CVD position of the means 8 for depositing the at least one PVD layer by physical vapour deposition, while the PVD position of the substrate 2 differs from the PVD position of the means 8 for depositing the at least one PVD layer by physical vapour deposition.

In the variant shown in Figure 4, the substrate holder 2 in its PVD position is arranged closer to the opening 2 than in its CVD position. Furthermore, in its CVD position, the substrate holder 2 is located in the chemical vapour deposition camber 3. In the variant shown in Figure 4, in the PVD position, the substrate holder 2 is located in the opening 5. In a variant not shown here, in the PVD position, the substrate holder 2 is located in the chemical vapour deposition chamber 3 even though at a different position than in the CVD position. In another variant not shown here, in the PVD position, the substrate holder 2 is located in the physical vapour deposition chamber 4. In these variants, the substrate holder 2 is moveable from the CVD position to the PVD position and back. Thereby, the movement of the substrate holder 2 is actuated by an actuator 25. This actuator 25 and thus the movement of the substrate holder 2 from the CVD position to the PVD position and back is controllable by the control unit 9.

In the apparatus 1 shown in the Figures 1 to 5, the entire substrate holder 2 together with the substrate 100 is rotatable around a substrate holder axis 16 for rotating the substrate 100 during deposition of the at least one CVD layer and during deposition of the at least one PVD layer. Thereby the apparatus 1 includes an actuator 17 for actuating this rotation of the substrate holder 2 around the substrate holder axis 16. In a variant however, only a part of the substrate holder together with the substrate is rotatable around the substrate holder axis for rotating the substrate during deposition of the at least one CVD layer and during deposition of the at least one PVD layer. In yet another example, neither the substrate holder nor the substrate is rotatable around a substrate holder axis.

The chemical vapour deposition chamber 3 is adapted for being operated in the chemical vapour deposition configuration at a pressure of less than 9·10⁻³ mbar for chemical vapour deposition of the at least one CVD layer. In a variant, the chemical vapour deposition chamber 3 is adapted for being operated in the chemical vapour deposition configuration at a pressure of less than 9·10⁻⁴ mbar for chemical vapour deposition of the at least one CVD layer. In order to obtain such a reduced pressure, the chemical vapour deposition chamber 3 includes a CVD vacuum port 21 for being connected to a CVD vacuum generating arrangement for obtaining the required reduced pressure inside the chemical vapour deposition chamber 3 in the chemical vapour deposition configuration. This CVD vacuum generating arrangement is not shown here. It can for example be a vacuum pump or a vacuum system of a laboratory building. In a variant, the apparatus 1 includes the CVD vacuum generating arrangement. Thereby, the CVD vacuum port 21 provides a first valve 22 for closing a connection line from the chemical vapour deposition chamber 3 via the CVD vacuum port 21 to the CVD vacuum generating arrangement in the physical vapour deposition configuration such that process gases and evaporated material in the chemical vapour deposition chamber cannot reach to the CVD vacuum generating arrangement.

Similarly, the physical vapour deposition chamber 4 is adapted for being operated in the physical vapour deposition configuration at a pressure of 9·10⁻⁸ mbar for physical vapour depositing the at least one PVD layer. In a variant, the physical vapour deposition chamber 4 is adapted for being operated in the physical vapour deposition configuration at a pressure of 9·10⁻⁹ mbar for physical vapour depositing the at least one PVD layer. This low pressure in the physical vapour deposition chamber 4 can for example be achieved in the physical vapour deposition configuration before the deposition of the at least one PVD layer is started. Once a plasma gas is introduced into the physical vapour deposition chamber 4 for generating therefrom the plasma for depositing the at least one PVD layer, the pressure in the physical vapour deposition chamber may for example rise to about 10⁻² mbar.

In order to achieve these reduced pressures, the physical vapour deposition chamber 4 includes a PVD vacuum port 23 for being connected to a PVD vacuum generating arrangement for obtaining this reduced pressure inside the chemical vapour deposition chamber 3 and the physical vapour deposition chamber 4 in the physical vapour deposition configuration.

This PVD vacuum generating arrangement is not shown here. It can for example be a vacuum pump or a vacuum system of a laboratory building. In a variant, the apparatus 1 includes the PVD vacuum generating arrangement. Thereby, the PVD vacuum port 23 provides a second valve 24 for closing a connection line from the physical vapour deposition chamber 4 via the PVD vacuum port 23 to the PVD vacuum generating arrangement in the chemical vapour deposition configuration such that process gases in the chemical vapour deposition chamber 3 and the physical vapour deposition chamber 4 cannot reach to the PVD vacuum generating arrangement.

The invention is not limited to the apparatus described above in the context of the figures. Further variants and variants of the apparatus pertaining to the invention are readily available to the person skilled in the art.

In summary, it is to be noted that an apparatus is provided for depositing material layers on a substrate with chemical vapour deposition, in particular atomic layer deposition, and physical vapour deposition, pertaining to the technical field initially mentioned, that enables a reliable, fast and efficient deposition of different material layers with chemical vapour deposition and physical vapour deposition on the substrate, the material layers being very homogeneous and having a uniform thickness.

## Claims

1. An apparatus (1) for depositing material layers on a substrate (100) with chemical vapour deposition, in particular atomic layer deposition, and physical vapour deposition, said apparatus (1) including:
a) a substrate holder (2) for holding said substrate (100) during deposition of said material layers,
b) a chemical vapour deposition chamber (3), in particular an atomic layer deposition chamber,
c) a physical vapour deposition chamber (4), wherein said physical vapour deposition chamber (4) and said chemical vapour deposition chamber (3) are interconnected via an opening (5) having a minimal opening diameter,
d) a sealing device (6) for isolating said chemical vapour deposition chamber (3) from said physical vapour deposition chamber (4) by sealing said opening (5), said sealing device (6) being switchable between a sealing state in which sealing state said chemical vapour deposition chamber (3) is isolated from said physical vapour deposition chamber (4) in that said opening (5) is sealed by said sealing device (6), and an unsealing state in which unsealing state said isolation of said chemical vapour deposition chamber (3) from said physical vapour deposition chamber (4) by said sealing device (6) is revoked,
e) means (8) for depositing at least one PVD layer by physical vapour deposition on said substrate (100), each one of said at least one PVD layer being one of said material layers, wherein said apparatus (1) is switchable to a physical vapour deposition configuration for depositing said at least one PVD layer with said means (8) for depositing said at least one PVD layer by physical vapour deposition on said substrate (100),
f) means (7) for depositing at least one CVD layer by chemical vapour deposition, in particular by atomic layer deposition, on said substrate (100), each one of said at least one CVD layer being one of said material layers, wherein said apparatus (1) is switchable to a chemical vapour deposition configuration for depositing said at least one CVD layer with said means (7) for depositing said at least one CVD layer by chemical vapour deposition on said substrate (100),
**characterised in that** in said physical vapour deposition configuration, a distance between said substrate holder (2) and said means (8) for depositing said at least one PVD layer by physical vapour deposition is smaller than said minimal opening diameter.

2. The apparatus (1) according to claim 1, **characterised in that** in said physical vapour deposition configuration, said distance between said substrate holder (2) and said means (8) for depositing said at least one PVD layer by physical vapour deposition is smaller than 30 cm, advantageously smaller than 20 cm, particular advantageously less than 10 cm.

3. The apparatus (1) according to claim 1 or 2, **characterised in that** in said physical vapour deposition configuration, said distance between said substrate holder (2) and said means (8) for depositing said at least one PVD layer by physical vapour deposition is larger than 2 cm, preferably larger than 3 cm, more preferably larger than 4 cm, most preferably larger than 5 cm.

4. The apparatus (1) according to one of claims 1 to 3, **characterised in that** said apparatus (1) includes a control unit (9) for controlling said apparatus (1) for depositing said material layers on said substrate (100) with chemical vapour deposition, in particular atomic layer deposition, and physical vapour deposition.

5. The apparatus (1) according to one of claims 1 to 4, **characterised in that** said means (8) for depositing said at least one PVD layer by physical vapour deposition on said substrate (100) includes a sputter source (10) for sputter depositing said at least one PVD layer by sputtering sputter target material from a sputter target (11), wherein said distance between said substrate holder (2) and said means (8) for depositing said at least one PVD layer by physical vapour deposition is the distance between said substrate holder (2) and said sputter source (10).

6. The apparatus (1) according to claim 5, **characterised in that** said apparatus (1) is adapted such that in said physical vapour deposition configuration, during depositing said at least one PVD layer, said distance between said substrate holder (2) and said means (8) for depositing said at least one PVD layer is larger than a height above the sputter target (11) of a plasma sheath (13) produced during sputter depositing said at least one PVD layer with said sputter source (10).

7. The apparatus (1) according to claim 5 or 6, **characterised in that** said apparatus (1) is adapted such that in said physical vapour deposition configuration, during depositing said at least one PVD layer, a plasma sheath (13) produced during sputter depositing said at least one PVD layer with said sputter source (10) reaches from the sputter target (11) at least into said opening (5).

8. The apparatus (1) according to one of claims 1 to 7, **characterised in that** in said physical vapour deposition configuration, said means (8) for depositing said at least one PVD layer by physical vapour deposition is arranged at least partially, in particular fully, in said physical vapour deposition chamber (3).

9. The apparatus (1) according to one of claims 1 to 8, **characterised in that** in said physical vapour deposition configuration and in said chemical vapour deposition configuration, said means (8) for depositing said at least one PVD layer by physical vapour deposition is arranged at a same position in said physical vapour deposition chamber (4).

10. The apparatus (1) according to claim 1 or 9, **characterised in that** in said physical vapour deposition configuration, said sealing device (6) is in the unsealing state.

11. The apparatus (1) according to claim 1 or 10, **characterised in that** in said chemical vapour deposition configuration, said sealing device (6) is in the sealing state.

12. The apparatus (1) according to claim 1 or 11, **characterised in that** in said chemical vapour deposition configuration, said means (7) for depositing said at least one CVD layer by chemical vapour deposition is arranged in said chemical vapour deposition chamber (3).

13. The apparatus (1) according to one of claims 1 to 12, **characterised in that** in said physical vapour deposition configuration and in said chemical vapour deposition configuration, said substrate holder (2) is arranged at a same position in said chemical vapour deposition chamber (3).

14. The apparatus (1) according to one of claims 1 to 13, **characterised in that** said substrate holder (2) is rotatable around a substrate holder axis (16) for rotating the substrate (100) held in said substrate holder (2) around said axis during deposition of said at least one CVD layer and/or during deposition of said at least one PVD layer.

15. The apparatus (1) according to one of claims 1 to 14, **characterised in that** said sealing device (6) is a gate valve providing a closed state being said sealing state and an open state being said unsealing state.
